## Europäisches Patentamt
## European Patent Office
## Office européen des brevets

(19)

(11) Veröffentlichungsnummer: **0 188 662**
**B1**

(12) **EUROPÄISCHE PATENTSCHRIFT**

(45) Veröffentlichungstag der Patentschrift:
**28.12.88**

(51) Int. Cl.⁴: **H 03 D 7/00, H 03 J 5/24**

(21) Anmeldenummer: **85112385.1**

(22) Anmeldetag: **01.10.85**

(54) **Frequenzumsetzer.**

(30) Priorität: **24.01.85 DE 3502294**

(43) Veröffentlichungstag der Anmeldung:
**30.07.86 Patentblatt 86/31**

(45) Bekanntmachung des Hinweises auf die Patenterteilung:
**28.12.88 Patentblatt 88/52**

(84) Benannte Vertragsstaaten:
**AT CH DE LI NL**

(56) Entgegenhaltungen:
**US-A- 3 831 097**
**US-A- 4 367 560**
**US-A- 4 457 022**

(73) Patentinhaber: **ANT Nachrichtentechnik GmbH,
Gerberstrasse 33, D-7150 Backnang (DE)**

(72) Erfinder: **Zehelein, Günther, Dipl.-Ing., Südstrasse 117,
D-7150 Backnang (DE)**
Erfinder: **Magnus, Jürgen, Dipl.-Ing., Sonnenhalde 24,
D-7151 Allmersbach i.T.-Heutensbach (DE)**

EP 0 188 662 B1

## Beschreibung

Die vorliegende Erfindung betrifft einen Frequenzumsetzer, bestehend aus einem Mischer mit einem Eingang für ein Oszillatorsignal, einem anderen Eingang für ein Hochfrequenzsignal und zwei Ausgängen, an denen zwei durch die Mischung entstandene, gegeneinander phasenverdrehte Zwischenfrequenzteilsignale anliegen, und aus einem an die Mischerausgänge angeschlossenen Koppler, der die beiden Zwischenfrequenzteilsignale an einem seiner zwei Ausgänge gleichphasig überlagert und an seinem anderen Ausgang mit einem Anpassungswiderstand abgeschlossen ist, wobei die im Mischer erzeugten Spiegelfrequenzsignale entgegengesetzte Phasenlagen annehmen und sich gegenseitig kompensieren.

Ein derartiger Frequenzumsetzer ist aus der US-A-3 831 097 bekannt. Der aus dieser Schrift hervorgehende Frequenzumsetzer besitzt keine Mittel, die dafür sorgen, dass bei Frequenzänderungen des am Eingang anliegenden Hochfrequenzsignals die Frequenz des Zwischenfrequenzsignals am Ausgang stets konstant ist.

Hier wird aber von einem Hochfrequenzempfänger ausgegangen zum Empfang von Signalen mit verschiedenen, innerhalb eines vorgegebenen Frequenzbandes liegenden Frequenzen. Diese unterschiedlichen Empfangssignalfrequenzen sollen in eine für die Demodulation geeignete, festliegende Zwischenfrequenz umgesetzt werden.

Der Erfindung liegt nun die Aufgabe zugrunde, einen Frequenzumsetzer der eingangs genannten Art anzugeben, der in der Lage ist, unterschiedliche Signalfrequenzen in eine fest vorgegebene Zwischenfrequenz umzusetzen, wobei die für die Umsetzung erforderliche Oszillatorfrequenz nur in einem möglichst schmalen Frequenzbereich durchstimmbar sein muss.

Erfindungsgemäss wird diese Aufgabe durch die im Anspruch 1 angegebenen Merkmale gelöst.

Zweckmässige Ausführungen der Erfindung gehen aus den Unteransprüchen hervor.

Dadurch, dass der dieser Erfindung zugrunde liegende Frequenzumsetzer nur einen schmalen Durchstimmbereich der Oszillatorfrequenz erfordert, vereinfachen sich die Schaltungen für den Oszillator und andere nachfolgende Funktionseinheiten (z.B. Frequenzvervielfacher).

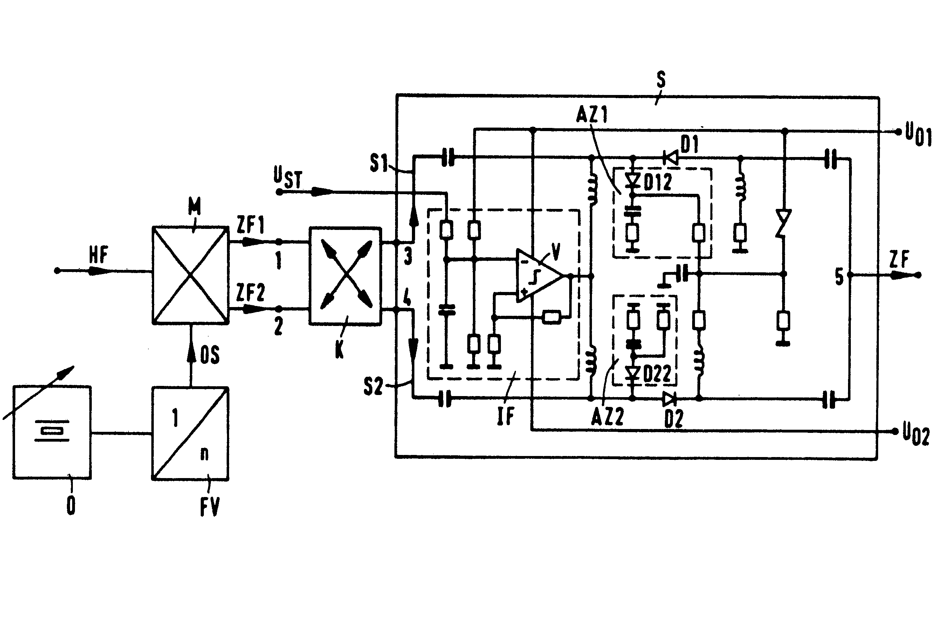

Anhand eines in der Zeichnung dargestellten Ausführungsbeispiels, wird nachfolgend die Erfindung näher erläutert.

Der aus der Zeichnung hervorgehende Frequenzumsetzer besitzt einen Mischer M, an dessen einem Eingang ein empfangenes Hochfrequenzsignal HF und an dessen anderem Eingang ein Oszillatorsignal OS anliegt. Das Oszillatorsignal OS kommt von einem in der Frequenz durchstimmbaren Oszillator O und gelangt über einen Frequenzvervielfacher FV an den Mischer M.

Bei dem Mischer M handelt es sich um einen symmetrischen Gegentaktmischer, der an zwei Ausgängen 1 und 2 zwei durch die Mischung der Oszillatorfrequenz $f_{OS}$ mit der Frequenz $f_{HF}$ des Hochfrequenzsignals HF entstandene Zwischenfrequenzteilsignale ZF1 und ZF2 liefert, die gleichgrosse Amplituden haben, aber gegeneinander um 90° phasenverschoben sind.

In den Ausgängen 1 und 2 des Mischers M ist ein 90°-3dB-Koppler K angeschlossen. Dieser 3-dB-Koppler K überlagert die um 90° gegeneinander phasenverschobenen Zwischenfrequenzteilsignale ZF1 und ZF2 an einem seiner Ausgänge 3 oder 4 und bewirkt dass die durch Mischung des vom HF-Verstärker verstärkten breitbandigen Rauschens entstandenen Spiegelfrequenzsignale entgegengesetzte Phasenlagen annehmen und dadurch sich gegenseitig kompensieren.

Die Zwischenfrequenzteilsignale ZF1 und ZF2 werden im Mischer M entweder durch Aufwärts- oder durch Abwärtsmischung erzeugt. Für den Fall, dass das empfangene Hochfrequenzsignal HF mit seiner Frequenz $f_{HF}$ in der unteren Hälfte des Frequenzbandes liegt, das als möglicher Bereich für das Auftreten der Frequenz des Hochfrequenzsignals überhaupt in Frage kommt, werden die Zwischenfrequenzteilsignale ZF1 und ZF2 mit der vorgegebenen konstanten Zwischenfrequenz $f_{ZF}$ durch Aufwärtsmischung gebildet. Dagegen werden die Zwischenfrequenzteilsignale für den Fall, dass die Frequenz $f_{HF}$ des Hochfrequenzsignals HF in der oberen Hälfte des besagten Frequenzbandes liegt, durch Abwärtsmischung erzeugt.

Für die Aufwärtsmischung wird das Oszillatorsignal OS auf eine solche Frequenz $f_{OS}$ oberhalb der Frequenz $f_{HF}$ des Hochfrequenzsignals abgestimmt, dass die Differenz aus der Oszillatorfrequenz $f_{OS}$ und der Frequenz $f_{HF}$ des Hochfrequenzsignals die gewünschte konstante Zwischenfrequenz $f_{ZF}$ ergibt. Es gilt nämlich bei der Aufwärtsmischung die Beziehung zwischen den Frequenzen:

$$f_{ZF} = f_{OS} - f_{HF}$$

Demgegenüber wird für die Abwärtsmischung das Oszillatorsignal OS auf eine solche Frequenz $f_{OS}$ unterhalb der Frequenz $f_{HF}$ des Hochfrequenzsignals HF abgestimmt, dass die Differenz aus der Frequenz $f_{HF}$ des Hochfrequenzsignals und der Oszillatorfrequenz $f_{OS}$ ebenfalls die konstante Zwischenfrequenz $f_{ZF}$ ergibt. Bei der Abwärtsmischung gilt nämlich die Beziehung zwischen den Frequenzen:

$$f_{ZF} = f_{HF} - f_{OS}$$

Auf Grund der soeben beschriebenen Anwendung von Aufwärts- und Abwärtsmischung zum Erzeugen der fest vorgegebenen Zwischenfrequenz $f_{ZF}$ braucht die Oszillatorfrequenz $f_{OS}$ nur in einem Frequenzbereich durchstimmbar zu sein, der halb so gross ist wie das Frequenzband, innerhalb dessen die die Frequenz des Hochfrequenzsignals varrieren kann. Dabei wird für die Aufwärtsmischung wie für die Abwärtsmischung der gleiche Durchstimmbereich der Oszillatorfrequenz ausgenutzt.

Ein Wechsel von Aufwärts- auf Abwärtsmischung und umgekehrt hat auch einen Wechsel der Phasenlagen der an den Ausgängen 1 und 2 des Mischers M anliegenden Zwischenfrequenzteilsignale ZF1 und ZF2 zur Folge. Je nach Phasenlage überlagern sich dann die Zwischenfrequenzteilsignale entweder am Ausgang 3 oder am Ausgang 4 des anschliessenden 3dB-Kopplers K. Das gewünschte, aus der Überlagerung der Zwischenfrequenzteilsignale entstandene Zwischenfrequenzsignal ZF kann also, je nachdem ob eine Aufwärts- oder Abwärtsmischung vorliegt, entweder am Ausgang 3 oder am Ausgang 4 des 3dB-Kopplers abgegriffen werden.

Ein an die Ausgänge 3 und 4 des Kopplers K angeschlossener elektronisch steuerbarer Schalter S sorgt dafür, dass immer der das Zwischenfrequenzsignal ZF liefernde Kopplerausgang an die Schalterausgangsklemme 5 durchgeschaltet und der jeweils andere Kopplerausgang reflexionsfrei mit einem Anpassungswiderstand abgeschlossen wird.

Der Schalter S hat zwei an der Ausgangsklemme 5 zusammenlaufende Signalwege S1 und S2, von denen der Signalweg S1 an den Kopplerausgang 3 und der Signalweg S2 an den Kopplerausgang 4 angeschlossen ist. Jeder Signalweg S1, S2 weist eine Abzweigung AZ1, AZ2 mit einem Widerstandsnetzwerk auf, welches den Anpassungswiderstand für den Koppler K darstellt.

In die Signalwege S1 und S2 sind Dioden D1 und D2 (z.B. PIN-Dioden) und in die Abzweigungen AZ1 und AZ2 ebenfalls Dioden D12 und D22 eingefügt. Diese Dioden D1, D12, D2, D22 sind jeweils so gepolt, dass, wenn sie alle z.B. mit einer positiven Spannung angesteuert werden, der erste Signalweg S1 bzw. S2 von Koppler K zur Ausgangsklemme 5 durchgeschaltet ist und der zweite Signalweg S2 bzw. S1 von der Ausgangsklemme abgeschaltet, aber seine Abzweigung AZ2 bzw. AZ1 zum Koppler durchgeschaltet ist. Dagegen ist bei einer Ansteuerung der Dioden mit einer negativen Spannung der zweite Signalweg S2 bzw. S1 vom Koppler K zur Ausgangsklemme 5 durchgeschaltet, und der erste Signalweg S1 bzw. S2 von der Ausgangsklemme 5 abgeschaltet, aber seine Abzweigung AZ1 bzw. AZ2 zum Koppler durchgeschaltet. Die Steuerspannungen erhalten die Dioden von einem Impulsformernetzwerk IF, das eine von einem Prozessor (in der Zeichnung nicht dargestellt) abgegebene Steuerspannung $U_{ST}$ in Impulse mit hoher Flankensteilheit und erforderlicher Amplitudenhöhe umformt. Mit $U_{01}$ und $U_{02}$ sind in der Schaltung die Betriebsspannungen für einen in dem Impulsformernetzwerk IF vorhandenen Differenzverstärker V bezeichnet.

Der angesprochene Prozessor ermittelt aus der Frequenz des empfangenen Hochfrequenzsignals, ob die Zwischenfrequenz durch Aufwärts- oder Abwärtsmischung gebildet werden soll und steuert dementsprechend den durchstimmbaren Oszillator und mit seiner Steuerspannung $U_{ST}$ den Schalter S, so dass dieser immer den das Zwischenfrequenzsignal ZF bereitstellenden Kopplerausgang an die Ausgangsklemme 5 durchschaltet.

**Patentansprüche**

1. Frequenzumsetzer, bestehend aus einem Mischer (M) mit einem Eingang für ein Oszillatorsignal (OS), einem anderen Eingang für ein Hochfrequenzsignal (HF) und zwei Ausgängen (1, 2), an denen zwei durch die Mischung entstandene, gegeneinander phasenverdrehte Zwischenfrequenzteilsignale (ZF1, ZF2) anliegen, und aus einem an die Mischerausgänge angeschlossenen Koppler (K), der die beiden Zwischenfrequenzteilsignale an einem seiner zwei Ausgänge (3, 4) gleichphasig überlagert und an seinem anderen Ausgang mit einem Anpassungswiderstand abgeschlossen ist, wobei die im Mischer erzeugten Spiegelfrequenzsignale entgegengesetzte Phasenlagen annehmen, und sich gegenseitig kompensieren, dadurch gekennzeichnet, dass die Zwischenfrequenzsignale (ZF1 ZF2) durch Aufwärtsmischung entstehen, wenn die Frequenz ($f_{HF}$) des Hochfrequenzsignales (HF) in einem unteren Bereich des Frequenzbandes liegt, in dem das Hochfrequenzsignal irgendeine beliebige Frequenz annehmen kann, dass die Zwischenfrequenzteilsignale (ZF1, ZF2) durch Abwärtsmischung entstehen, wenn die Frequenz $f_{HF}$ des Hochfrequenzsignals (HF) in einem oberen Bereich des besagten Frequenzbandes liegt, wobei für die Aufwärtsmischung das Oszillatorsignal (OS) auf eine solche Frequenz $f_{OS}$, die über der Frequenz $f_{HF}$ des Hochfrequenzsignals liegt, abgestimmt ist, so dass jeweils die Differenz aus der Oszillatorfrequenz $f_{OS}$ und der Frequenz $f_{HF}$ des Hochfrequenzsignales einen fest vorgegebenen Wert ergibt, und für die Abwärtsmischung das Oszillatorsignal (OS) auf eine solche Frequenz $f_{OS}$, die unter der Frequenz $f_{HF}$ des Hochfrequenzsignals liegt, abgestimmt ist, so dass jeweils die Differenz aus der Frequenz $f_{HF}$ des Hochfrequenzsignals und der Oszillatorfrequenz $f_{OS}$ denselben fest vorgegebenen Wert ergibt, und dass an den beiden Ausgängen (3, 4) des Kopplers (K) ein Schalter (S) angeschlossen ist, der jeweils den Kopplerausgang (3, 4), an dem das durch die gleichphasige Überlagerung der Zwischenfrequenzteilsignale (ZF1, ZF2) entstandene Zwischenfrequenzsignal (ZF) anliegt, durchschaltet und an den anderen Kopplerausgag den Anpassungswiderstand anschaltet.

2. Frequenzumsetzer nach Anspruch 1, dadurch gekennzeichnet, dass der Koppler (K) ein 90°-3dB-Koppler ist.

3. Frequenzumsetzer nach Anspruch 1, dadurch gekennzeichnet, dass der Schalter (S) zwei an einer Ausgangsklemme (5) zusammenlaufende, an die beiden Kopplerausgänge (3, 4) angeschlossene Signalwege (S1, S2) aufweist, dass jeder Signalweg (S1, S2) eine Abzweigung (AZ1, AZ2) mit einem Anpassungswiderstand für den Koppler (K) besitzt, dass jeder Signalweg (S1, S2) und dessen Abzweigung (AZ1, AZ2) ein Diodennetzwerk (D1, D12, D2, D22) enthält, das jeweils so gepolt ist, dass bei einer an die Diodennetzwerke gelegten positiven Steuerspannung der erste Signalweg zur Ausgangsklemme (5) und an den zweiten Signalweg der Anpassungswiderstand durchgeschaltet ist, und dass bei einer negativen Steuerspannung der zweite Signalweg zur Ausgangsklemme (5) und an den ersten Signalweg der Anpassungswiderstand durchgeschaltet ist.

**Revendications**

1. Changeur de fréquence, constitué d'un mélangeur (M) avec une entrée pour un signal d'oscillateur (OS), une autre entrée pour un signal haute fréquence (HF) et deux sorties (1, 2), auxquelles sont appliqués deux signaux partiels de fréquence intermédiaire (ZF1, ZF2) produits par le mélange et mutuellement déphasés, ainsi que d'un coupleur (K) raccordé aux sorties du mélangeur, qui superpose les deux signaux partiels de fréquence intermédiaire avec la même phase à l'une de ses deux sorties (3, 4) et dont l'autre sortie est terminée par une résistance d'adaptation, les signaux de fréquence-image produits dans le mélangeur prenant des positions de phase opposées et se compensant mutuellement, caractérisé en ce que les signaux partiels de fréquence intermédiaire (ZF1, ZF2) se forment par mélange vers le haut lorsque la fréquence (f $_{HF}$) du signal haute fréquence (HF) se trouve dans une gamme inférieure de la bande de fréquences, dans laquelle le signal haute fréquence peut prendre une fréquence quelconque, que les signaux partiels de fréquence intermédiaire (ZF1, ZF2) se forment par mélange vers le bas lorsque la fréqunce $f_{HF}$ du signal haute fréquence (HF) se trouve dans une gamme supérieure de ladite bande de fréquences, le signal d'oscillateur (OS) étant accordé, pour le mélange vers le haut, à une telle fréquence $f_{OS}$ supérieure à la fréquence $f_{HF}$ du signal haute fréquence, que la différence de la fréquence d'oscillateur $f_{OS}$ et de la fréquence $f_{HF}$ du signal haute fréquence correspond chaque fois à une valeur préfixée, et le signal d'oscillateur (OS) étant accordé, pour le mélange vers le bas, à une telle fréquence $f_{OS}$ inférieure à la fréquence $f_{HF}$ du signal haute fréquence, que la différence de la fréquence $f_{HF}$ du signal haute fréquence et de la fréquence d'oscilateur $f_{OS}$ donne chaque fois la même valeur préfixée, et qu'un interrupteur (S) est raccordé aux deux sorties (3, 4) du coupleur (K), interrupteur qui établit chaque fois la connexion à la partie suivante du circuit de la sortie de coupleur (3, 4) à laquelle est appliqué le signal de fréquence intermédiaire (ZF) formé par la superposition en phase des signaux partiels de fréquence intermédiaire (ZF1, ZF2) et qui connecte la résistance d'adaptation à l'autre sortie du coupleur.

2. Changeur de fréquence selon la revendication 1, caractérisé en ce que le coupleur (K) est un coupleur 90° à 3kB.

3. Changeur de fréquence selon la revendication 1, caractérisé en ce que l'interrupteur (S) présente deux itinéraires de signal (S1, S2) raccordés aux deux sorties (3, 4) du coupleur, que chaque itinéraire de signal (S1, S2) possède une dérivation (AZ1, AZ2) avec une résistance d'adaptation pour le coupleur (K), que chaque itinéraire de signal (S1, S2) et sa dérivation (AZ1, AZ2) contiennent un réseau de diodes (D1, D12, D2, D22) dont la polarité est telle que, lorsqu'une tension de commande positive est appliquée aux réseaux de diodes, le premier itinéraire de signal est relié à la borne de sortie (5) et la résistance d'adaptation est reliée au second itinéraire de signal et, lorsqu'une tension de commande négative est appliquée, le second itinéraire de signal est relié à la borne de sortie (5) et la résistance d'adaptation est reliée au premier itinéraire de signal.

**Claims**

1. A frequency converter, comprising a mixer (M) having one input for an oscillator signal (OS), another input for a high frequency signal (HF) and two outputs (1, 2) at which two intermediate frequency partial signals (ZF1, ZF2) that are out of phase with one another and produced by the mixing are present, and comprising a coupler (K) connected to the mixer outputs, which superimposes the two intermediate frequency partial signals at one of its two outputs (3, 4) in phase with one another and is closed off at its other output with an adaptation resistor, wherein the image frequency signals generated in the mixer assume opposite phase positions and compensate for on another, characterized in that the intermediate frequency partial signals, (ZF1, ZF2) are produced by upward mixing, whenever the frequency ($f_{HF}$) of the high-frequency signal (HF) is located in a lower range of the freuqency band, in which the high-frequency signal can assume any arbitrary frequency; that the intermediate frequency partial signals (ZF1, ZF2) are produced by downward mixing, whenever the frequency $f_{HF}$ of the high-frequency signal (HF) is located in an upper range of said frequency band, wherein for the upward mixing, the oscillator signal (OS) is tuned to a frequency $f_{OS}$ which is above the frequency $f_{HF}$ of the high-frequency signal, so that in each case the difference between the oscillator frequency $f_{OS}$ and the frequency $f_{HF}$ of the high-frequency signal has a fixedly predetermined value, and for the downward mixing the oscillator signal (OS) is tuned to a frequency $f_{OS}$ such as to be below the frequency $f_{HF}$ of the high-frequency signal, so that the difference between the frequency $f_{HF}$ of the high-frequency signal and the oscillator frequency $f_{OS}$ in each case has the same fixedly predetermined value; and that connected to the two outputs (3, 4) of the coupler (K) is a switch (S), which switches through whichever one of the coupler outputs (3, 4) at which the intermediate frequency signal (ZF) produced by the in-phase superposition of the intermediate frequency partial signals (ZF1, ZF2) is present, and connects the adaptation resistor to the other coupler output.

2. A frequency converter as defined by claim 1, characterized in that the coupler (K) is a 90°-3dB-coupler.

3. A frequency converter as definded by claim 1, characterized in that the switch (S) has two signal paths (S1, S2) converting at an output terminal (5) and connected to the two coupler outputs (3, 4); that each signal path (S1, S2) has a branch (AZ1, AZ2) having an adaptation resistor for the coupler (K); that each signal path (S1, S2) and its branch (AZ1, AZ2) includes a diode array (D1, D12, D2, D22), which in each case is polarized such that at a positive control voltage applied to the diode arrays, the first signal route is switched through to the output terminal (5) and the adaptation resistor is switched through to the second signal path; and that at a negative control voltage the second signal path is switched through to the output terminal (5) and the adaptation resistor is switched through to the first signal path.

1/1